# EUROPEAN PATENT APPLICATION

(11) **EP 1 801 261 A1**
(43) Date of publication of application: **27.06.2007**
(21) Application number: 06126331.5
(22) Date of filing: 18.12.2006
(51) Int. Cl.: C23C 16/48, C23C 10/06

(54) **Chemical vapor deposition apparatus and methods of using the apparatus**

(30) Priority: 22.12.2005 US 315710
(71) Applicant: The General Electric Company, Schenectady NY 12345 (US)
(72) Inventor: Lewis, Daniel Joseph, Delmar, OH 12054 (US); Lou, Victor Lienkong, Niskayuna, NY 12309 (US); Dalakos, George Theodore, Niskayuna, NY 12309 (US); Saylor, Matthew David, Blanchester, OH 45107 (US); Weaver, Scott Andrew, Ballston Lake, NY 12019 (US); Rucker, Michael Howard, Cincinnati, OH 45209 (US)
(74) Representative: Bedford, Grant Richard

(57) **Abstract**

A chemical vapor deposition apparatus (10) comprises a heating element (12) capable of emitting electromagnetic radiation; a retort (16) positioned relative to the heating element (12) to receive the electromagnetic radiation; an encasing member (18) at least partially disposed around the retort (16), the encasing member (18) comprising a material that is at least partially transparent to the electromagnetic radiation; a plenum (20) defined at least in part by an inner surface (24) of the encasing member (18) and an outer surface (22) of the retort (16) ; and a furnace box (14) at least partially disposed around the encasing member (18) and the retort (16), and housing the heating element (12).

## Description

The present disclosure generally relates to chemical vapor deposition (CVD) apparatuses, and more particularly to radiant heated CVD furnaces, and methods of using the CVD furnaces.

There are numerous methods for depositing films/coatings on substrates. One method for deposition is chemical vapor deposition. In chemical vapor deposition, the materials that are to be deposited are formed as a result of a chemical reaction between gaseous reactants at elevated temperatures in the vicinity of the substrate. The product of the reaction is then deposited on the surface of the substrate. Chemical vapor deposition can be used to deposit films/coatings of semiconducting materials (crystalline and non-crystalline), insulating materials, as well as metals.

Chemical vapor deposition is often performed in a coating container commonly referred to as a "retort". The substrate to be coated is placed within the retort along with the coating materials. The retort is heated to an elevated temperature sufficient for the gaseous reaction of the coating materials to occur. Typically, furnaces are used to heat the retort. For example, in infrared furnaces, radiant heat, such as heat from halogen infrared incandescent lamps, is used to heat the reactants in the retort. However, challenges exist in cooling these infrared lamps, while maintaining the processing temperature within the retort.

Accordingly, a continual need exists for improved furnace and retort designs.

Disclosed herein are chemical vapor deposition apparatus, and methods of using the chemical vapor deposition apparatus. In one embodiment, a chemical vapor deposition apparatus comprises a heating element capable of emitting electromagnetic radiation; a retort positioned relative to the heating element to receive the electromagnetic radiation; an encasing member at least partially disposed around the retort, the encasing member comprising a material that is at least partially transparent to the electromagnetic radiation; a plenum defined at least in part by an inner surface of the encasing member and an outer surface of the retort; and a furnace box at least partially disposed around the encasing member and the retort, and housing the heating element.

In another embodiment, a chemical vapor deposition apparatus comprises a heating element capable of emitting infra-red radiation; a retort comprising a first material that is at least partially transparent to the infra-red radiation or is capable of conducting radiant energy, the retort being positioned relative to the heating element to receive the infra-red radiation; an encasing member at least partially disposed around the retort, the encasing comprising a second material that is at least partially transparent to the infra-red radiation; a plenum defined at least in part by an inner surface of the encasing member and an outer surface of the retort; a furnace box at least partially disposed around the encasing member and the retort, and housing the heating element; and insulation disposed within the plenum at proximate ends of the retort such that during operation a temperature inside the plenum is greater than a temperature in the environment of the furnace box.

In one embodiment, a chemical vapor deposition method comprises disposing a work piece in a chamber of a retort, which is at least partially disposed within a encasing member such that a plenum is defined at least in part by an inner surface of the encasing member and an outer surface of the retort; transmitting electromagnetic radiation through the retort and the encasing member to heat environments of the chamber and the plenum; and coating the work piece with a coating material in the chamber when a temperature of the environment of the chamber has reached a predetermined temperature.

The above described and other features are exemplified by the following figures and detailed description, in which:
Figure 1 is a cross sectional view of an embodiment of a radiant heated chemical vapor deposition furnace; and
Figure 2 is a lengthwise cross sectional view of the radiant heated chemical vapor deposition furnace.

Disclosed herein are chemical vapor deposition apparatus and methods of using the chemical vapor deposition apparatus. As will be discussed in greater detail, the chemical vapor deposition apparatus is a radiant heated (e.g., infra-red heated) chemical vapor deposition furnace comprising a retort at least partially disposed with an encasing member. While the following discussion will be to radiant heated chemical vapor deposition furnaces and methods of using the furnaces for coating metal parts (e.g., turbine engine parts and components), it should also be understood that the furnaces can be used for heat treatments, brazes, coating operations, and the like for a variety of different applications (e.g., film disposition on semiconductor wafers).

As used herein, the terms "first," "second," and the like, herein do not denote any order, quantity, or importance, but rather are used to distinguish one element from another, and the terms "a" and "an" herein do not denote a limitation of quantity, but rather denote the presence of at least one of the referenced item. The suffix "(s)" as used herein is intended to include both the singular and the plural of the term that it modifies, thereby including one or more of that term (e.g., the metal(s) includes one or more metals).

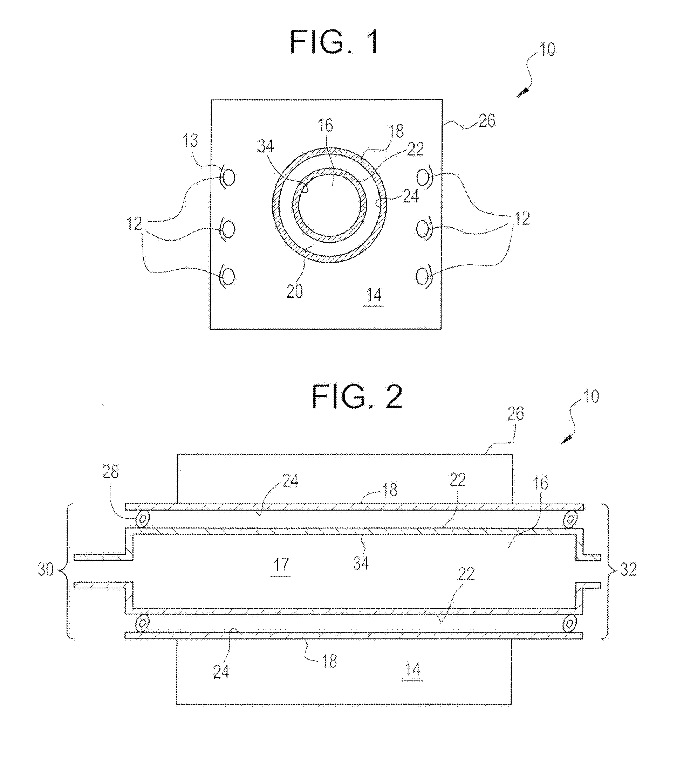

Figures 1-2 are cross sectional views of an embodiment of a chemical vapor deposition furnace, generally designated 10. The furnace 10 generally comprises a heating element 12, a furnace box 14, a retort 16, and an encasing member 18. At least one heating element 12 is disposed inside of the furnace box 14. Suitable heating elements 12 include, electro magnetic radiation (EMR) sources (e.g., sources of infra-red (IR) radiation, visible light, microwaves, and the like). In one embodiment, the heating elements 12 are infra-red (IR) heating lamps (e.g., tungsten-halogen lamps). For ease in discussion, reference is made hereinafter to infra-red heating elements 12 capable of emitting infra-red radiation (e.g., a wavelength of about 1 micrometer to about 1 millimeters). Optionally, a reflector 13 is positioned to reflect infra-red radiation from the heating elements 12 toward the retort 16.

While the term "box" is used in describing the furnace box 14, it should be understood that the furnace box 14 comprises any size and shape that allows at least a portion of the retort 16 that is heated to be disposed therein. For example, the furnace box 14 can comprise a cubical shape (e.g., box-like), rectangular shape, cylindrical shape, and the like. In one embodiment, the furnace box 14 comprises a clamshell design that allows the retort 16 to be easily removed from the furnace box 14. Stated another way, in one embodiment, the retort 16 is removably disposed within the furnace box 14. The retort 16 is horizontally or vertically disposed within the furnace box 14.

The retort 16 comprises any shape that allows for ease in manufacture and use (e.g., square, rectangular, tubular, and the like). The retort 16 is adapted to receive the work piece(s) (e.g., turbine engine parts or components) and reactive coating materials. More particularly stated, during operation, the work piece and coating materials are removably disposed in a chamber 17 of the retort 16. In various embodiments, a support unit (e.g., a rack) is optionally disposed within the chamber 17 to facilitate positioning and removal of the work piece. The material for the retort 16 is selected to transmit radiant energy (e.g., infra-red radiation) to the chamber 17. For example, radiant energy can be transmitted by conduction or any other suitable means of heat transfer. For example, air in a plenum 20 is heated by radiant energy being transmitted through the encasing member 18. This heated air transfers heat to the retort 16, which in turn transfers heat to the chamber 17. Alternatively, radiant energy can be directly transmitted through the retort material to heat the chamber 17. For example, in one embodiment, the retort 16 is at least partially transparent to infrared radiation. Suitable materials for the retort 16, include, but are not limited to, metal, quartz, quartz doped with alumina, alumina, synthetic silica, and combinations comprising at least one of the foregoing.

A coating material is optionally disposed on the retort 16 to act as a protective coating. In one embodiment, the coating material is disposed on an inner surface 34 of the retort 16. The coating material is selected to be compatible with the retort material. In one embodiment, the coating material comprises an oxide or a nitride. Further, the coating material is crystalline or glassy in structure. Suitable coating materials can include aluminum, yttrium, rare-earth elements, and combinations comprising at least one of the foregoing.

The encasing member 18 has a sufficient size and shape to accommodate the retort 16 being disposed therein. The retort 16 can be partially or completely disposed within the encasing member 18. In one embodiment, the encasing member 18 is at least partially transparent to infra-red radiation. Suitable materials for the encasing member 18 include, but are not limited to, those materials discussed above in relation to the retort 16. Moreover, the materials for the encasing member 18 can be the same or different than the materials for the retort 16.

The plenum 20 is defined at least in part by an inner surface 24 of the encasing member 18 and an outer surface 22 of the retort 16. Insulation 28 is disposed between and in physical communication with the inner surface 24 of the encasing member 18 and the outer surface 24 of the retort 16. More particularly, in one embodiment, the insulation 28 is disposed at peripheral ends 30 and 32 of the retort 16. The insulation 28 substantially thermally isolates the plenum 20 from an internal environment of the furnace box 14, which advantageously allows cooling (e.g., convention cooling) of the heating elements 12 without reducing the temperature within the retort 16. In other words, the atmosphere in the plenum 20 insulates the retort 16 from a cooling flow (e.g., airflow) over the heating elements 12. In one embodiment, the plenum 20 is hermetically sealed from the environment in the furnace box 14. By hermetically sealing the plenum 20, gases other than the air circulating in the furnace box can be employed in the plenum 20. The choice of the gas employed in the plenum 20 can be based on variables that include, but are not limited to, the pressure of the gas within the plenum when heated, the thermal conductivity of the gas, and the cost of the gas.

During operation, the work piece and coating materials are disposed in the chamber 17, the chamber 17 is sealed, and is then heated to the desired operating temperature with the heating elements 12. The coating materials (e.g., thermal barrier coating materials) and various other reactive materials vary depending on the desired application. The coating materials and other reactive materials are heated to a temperature sufficient to react, such that a coating is deposited onto the work piece. More particularly, energy (e.g., infra-red radiation) is transmitted from the heating elements 12 through the encasing member 18 and is transmitted by the retort 16 (e.g., by conduction) to the chamber 17, thereby heating the chamber 17 to the desired temperature. The infra-red radiation in turn also heats the gas in the plenum 20 providing a heated insulating layer around the retort 16.

By way of example, the coating material is discussed hereinafter in relation to an aluminide coating. For example, an aluminum source and a halide activator are disposed in the chamber 17 along with the work piece. The retort 16 is heated to a temperature sufficient for the gaseous reaction, e.g., a temperature of about 800°C to about 1,200°C. The particular temperature selected will depend on the coating application parameters desired (including the source of aluminide coating used) and other factors that would be understood by those skilled in the art. At these temperatures, the activator will form a reactive halide gas. Suitable halide activators, include but are not limited to, aluminum chloride, aluminum fluoride, aluminum bromide, ammonium chloride, ammonium fluoride, ammonium bromide, and combinations comprising at least one of the foregoing. Hydrogen chloride (a gas in its standard state) can also be used as the halide activator. The reactive halide gas reacts with the aluminum source to provide the aluminide coating gas, e.g., in the form of an aluminum halide gas. The aluminum source can be any aluminum or aluminum alloy, for example, cobalt aluminum alloys (CoAl), iron aluminum alloys (FeAl), or chromium aluminum alloys (CrAl), typically in powder or pelletized form.

In other embodiments, the reactive halide gas can be introduced into the retort 16 through one or more pipes that can be disposed in operable communication with the retort 16 via openings at the respect ends 30, 32 of the retort 16. In another embodiment, the aluminide coating gas can be generated in a reactor external to the retort 16, and then introduced into the retort 16 through one or more pipes. As would be understood by those skilled in the art, the reaction kinetics controlling the rate of formation of the aluminide coating gas will be dependent on the temperature, as well as the rate at which any carrier gas is introduced into the chamber 17.

As the aluminide coating gas flows over the surface of the work piece, the aluminide coating gas is reduced to aluminum, which is deposited on and diffuses into the work piece, thereby forming an aluminde coating on the work piece. The desired thickness of the aluminde coating depends on the desired application. Any remaining aluminde gas is purged from the chamber 17. Upon completion of the coating operation, the work piece is removed from the retort 16 and cooled or optionally cooled within the retort 16, while maintaining an inert gas atmosphere if desired.

Advantageously, the encasing member 18 that is disposed around the retort 18 allows the heating elements 12 to be convection cooled, e.g., by introducing air into the furnace box 14. This design permits the heating elements 12 to be cooled without water-cooling the heating elements 12. Active cooling, like water-cooling, can increase the design and operating cost of an infra-red heated furnaces. Since the heating elements 12 can be cooled without having to be water cooled, a significant commercial advantage can be realized in furnaces comprising a retort with an encasing member. Further advantages include, but are not limited to, rapid thermal transients and reduced cycle time when compared to furnaces comprising resisting heating elements.

While the disclosure has been described with reference to an exemplary embodiment, it will be understood by those skilled in the art that various changes may be made and equivalents may be substituted for elements thereof without departing from the scope of the disclosure. In addition, many modifications may be made to adapt a particular situation or material to the teachings of the disclosure without departing from the essential scope thereof. Therefore, it is intended that the disclosure not be limited to the particular embodiment disclosed as the mode contemplated for carrying out this disclosure, but that the disclosure will include all embodiments falling within the scope of the appended claims.

### Parts List

- 10: Infrared furnace
- 12: Heating element
- 14: Furnace box
- 16: Retort
- 18: Encasing member
- 20: Cooling plenum
- 22: Outer surface of retort
- 24: Inner surface of cooling jacket
- 26: Wall of furnace box
- 28: Insulation
- 30: End of retort
- 32: End of retort

## Claims

1. A chemical vapor deposition apparatus (10), comprising:
a heating element (12) capable of emitting electromagnetic radiation;
a retort (16) positioned relative to the heating element (12) to receive the electromagnetic radiation;
an encasing member (18) at least partially disposed around the retort (16), the encasing member (18) comprising a material that is at least partially transparent to the electromagnetic radiation;
a plenum (20) defined at least in part by an inner surface (24) of the encasing member (18) and an outer surface (22) of the retort (16) ; and
a furnace box (14) at least partially disposed around the encasing member (18) and the retort (16), and housing the heating element (12).

2. The chemical vapor deposition apparatus (10) of Claim 1, wherein the electromagnetic radiation is infra-red radiation having a wavelength of about 1 micrometer to about 1 millimeters.

3. The chemical vapor deposition apparatus (10) of Claim 1 or Claim 2, further comprising insulation (28) disposed within the plenum (20) such that during operation a temperature inside the plenum (20) is greater than a temperature in the environment of the furnace box (14).

4. The chemical vapor deposition apparatus (10) of Claim 3, wherein the insulation (28) is disposed within the plenum (20) at proximate ends (30, 32) of the retort (16).

5. The chemical vapor deposition apparatus (10) of any preceding Claim, wherein the retort (16) comprises a material that that is at least partially transparent to the electromagnetic radiation.

6. The chemical vapor deposition apparatus (10) of any preceding Claim, wherein the retort (16) comprises a material selected from the group consisting of metal, quartz, quartz doped with alumina, alumina, synthetic silica, and combinations comprising at least one of the foregoing.

7. The chemical vapor deposition apparatus (10) of any preceding Claim, further comprising a coating material disposed on the retort (16).

8. The chemical vapor deposition apparatus (10) of Claim 7, wherein the coating material comprises a nitride or an oxide.

9. The chemical vapor deposition apparatus (10) of Claim 7 or Claim 8, wherein the coating material comprises a material selected from the group consisting of aluminum, yttrium, rare-earth elements, and combinations comprising at least one of the foregoing.

10. The chemical vapor deposition apparatus (10) of any preceding Claim, wherein the retort is removably disposed within the furnace box (14).
